(19) Europäisches Patentamt
European Patent Office
Office européen des brevets

(11) **EP 3 640 071 B1**

(12) **EUROPEAN PATENT SPECIFICATION**

(45) Date of publication and mention
of the grant of the patent:
**05.05.2021 Bulletin 2021/18**

(51) Int Cl.:
*B60K 35/00* (2006.01)　　*G01R 31/392* (2019.01)
*B60L 58/16* (2019.01)　　*B60L 3/12* (2006.01)

(21) Application number: **19191400.1**

(22) Date of filing: **13.08.2019**

(54) **DISPLAY DEVICE AND VEHICLE INCLUDING THE SAME**

ANZEIGEVORRICHTUNG UND FAHRZEUG DAMIT

DISPOSITIF D'AFFICHAGE ET VÉHICULE LE COMPRENANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **19.10.2018 JP 2018197637**

(43) Date of publication of application:
**22.04.2020 Bulletin 2020/17**

(73) Proprietor: **TOYOTA JIDOSHA KABUSHIKI
KAISHA
Toyota-shi, Aichi 471 8571 (JP)**

(72) Inventors:
 • **KUBO, Kazuki
   Toyota-shi, Aichi 471-8571 (JP)**
 • **IZUMI, Junta
   Toyota-shi, Aichi 471-8571 (JP)**
 • **UCHIDA, Yoshihiro
   Toyota-shi, Aichi 471-8571 (JP)**
 • **UCHIYAMA, Masaki
   Toyota-shi, Aichi 471-8571 (JP)**

(74) Representative: **TBK
Bavariaring 4-6
80336 München (DE)**

(56) References cited:
**US-A1- 2018 050 601　US-A1- 2018 188 332
US-A1- 2018 299 511**

**Description**

BACKGROUND OF THE INVENTION

1. Field of the Invention

The present invention relates to display devices and vehicles including the same, and more particularly relates to display devices that display the degradation level of a secondary battery and vehicles including the same.

2. Description of Related Art

Vehicles such as electric vehicles are equipped with a secondary battery as a driving power supply (power source) for a motor. It is known that secondary batteries degrade over time and that the internal resistance of the secondary batteries increases and the full charge capacity of the secondary batteries decreases as they degrade. Various techniques for estimating the degradation level of a secondary battery have therefore been proposed. For example, Japanese Unexamined Patent Application Publication No. 2018-029430 (JP 2018-029430 A) and US2018188332A1 each describe a technique for calculating the degradation level of a secondary battery.

SUMMARY OF THE INVENTION

The degradation level of secondary batteries is an important factor for users. For example, in a vehicle equipped with a secondary battery, as the full charge capacity of the secondary battery decreases with its degradation, the distance the vehicle can travel with electric power stored in the secondary battery (what is called EV cruising range) decreases accordingly. By displaying the degradation level on a display unit of the vehicle, the user can see the current degradation level by looking at the display unit.

Secondary batteries degrade over time, and the degradation level of the secondary batteries monotonically increases over time. The expression "monotonically increase" means that the degradation level of a secondary battery at a certain point is equal to or higher than that of the secondary battery before that point.

The degradation level includes detection errors of various sensors that are used to calculate the degradation level, errors in calculation models, etc. Accordingly, there is a possibility that when the displayed degradation level is updated, the updated degradation level may be lower than that displayed degradation level due to the errors. In this case, the user may get confused by the display as it seems as if the secondary battery had become less degraded than before.

The present invention relates to display devices that display the degradation level of a secondary battery so that the user gets confused as little as possible by the display and vehicles including the same.

A first aspect of the present invention relates to a display device. The display device includes: a display unit configured to display a degradation level of a secondary battery; and a controller configured to calculate the degradation level from measurement data of the secondary battery in every predetermined period and to control the display unit so as to display the degradation level. The controller is configured to, when a first degradation level indicating a newly calculated degradation level of the secondary battery is lower than a second degradation level indicating a previously calculated degradation level of the secondary battery, correct the first degradation level to a value equal to or higher than the second degradation level and to control the display unit so as to display the corrected first degradation level.

With the above configuration, when the first degradation level indicating the newly calculated degradation level is lower than the second degradation level indicating the previously calculated degradation level, the first degradation level is corrected to a value equal to or higher than the second degradation level. Since the corrected first degradation level is thus displayed on the display unit, the degradation level of the secondary battery is restrained from being displayed as if the degradation level had decreased. This reduces or eliminates the possibility that the user may get confused by the display of the degradation level.

In the above aspect, the controller is configured to, when the first degradation level is lower than the second degradation level, correct the first degradation level to a value equal to the second degradation level and to control the display unit so as to display the corrected first degradation level.

With the above configuration, even when the first degradation level is lower than the second degradation level, the previously calculated second degradation level is displayed on the display unit. The degradation level of the secondary battery is thus restrained from being displayed as if the degradation level had decreased. This reduces or eliminates the possibility that the user may get confused by the display of the degradation level.

In the above aspect, the controller is configured to, when the first degradation level is lower than the second degradation level, correct the first degradation level to a degradation level estimated from the second degradation level and to control the display unit so as to display the corrected first degradation level.

Secondary batteries are known to have such degradation characteristics (degradation curve) that the degradation level increases with time. The current degradation level can thus be estimated from the previously calculated second degradation level. With the above configuration, when the first degradation level is lower than the second degradation level, the first degradation level is corrected to the current degradation estimated from the second degradation level. Since the corrected first degradation level is thus displayed on the display unit, the degradation level of the secondary battery is restrained from being displayed as if the degradation level had decreased. This reduces or eliminates the possibility that the user may get confused by the display of the degradation level.

In the above aspect, the controller is configured to calculate the first degradation level again when a difference between the first degradation level and the second degradation level is larger than a threshold.

For example, if the first degradation level is different from the second degradation level by an amount larger than the threshold, it is presumed that abnormality such as a calculation error has occurred. With the above configuration, if the first degradation level is different from the second degradation level by an amount larger than the threshold, the first degradation level is calculated again. The abnormal value is thus restrained from being displayed as the degradation level. This reduces or eliminates the possibility that the user may get confused by the display of the degradation level.

A second aspect of the present invention relates to a vehicle. The vehicle includes: a secondary battery; and a display device including a display unit and a controller. The display unit is configured to display a degradation level of the secondary battery. The controller is configured to calculate the degradation level from measurement data of the secondary battery in every predetermined period. The controller is configured to control the display unit so as to display the degradation level. The controller is configured to, when a first degradation level indicating a newly calculated degradation level is lower than a second degradation level indicating a previously calculated degradation level, correct the first degradation level to a value equal to or higher than the second degradation level and to control the display unit so as to display the corrected first degradation level.

According to the display device and the vehicle of the present invention, the degradation level of the secondary battery can be displayed so that the user gets confused as little as possible by the display.

BRIEF DESCRIPTION OF THE DRAWINGS

Features, advantages, and technical and industrial significance of exemplary embodiments of the invention will be described below with reference to the accompanying drawings, in which like numerals denote like elements, and wherein:

FIG. 1 is a block diagram showing an example of the configuration of a vehicle to which a display device according to an embodiment is applied;
FIG. 2 is a diagram showing an example of display on a display unit;
FIG. 3 is a graph showing an example of degradation characteristics (degradation curve) indicating degradation of a main battery over time;
FIG. 4 is a flowchart illustrating a process of accumulating measurement data;
FIG. 5 is a flowchart illustrating an example of a process of displaying the capacity retention of the main battery on a display unit;
FIG. 6 is a graph illustrating correction of the capacity retention;
FIG. 7 is a block diagram showing an example of the configuration in which the degradation level of the main battery is calculated, corrected, and displayed outside a vehicle; and
FIG. 8 is a block diagram showing an example of the configuration in which the degradation level of the main battery is calculated and corrected outside a vehicle.

DETAILED DESCRIPTION OF EMBODIMENTS

An embodiment of the present invention will be described in detail with reference to the accompanying drawings. In the figures, the same or corresponding portions are denoted with the same reference characters and description thereof will not be repeated.

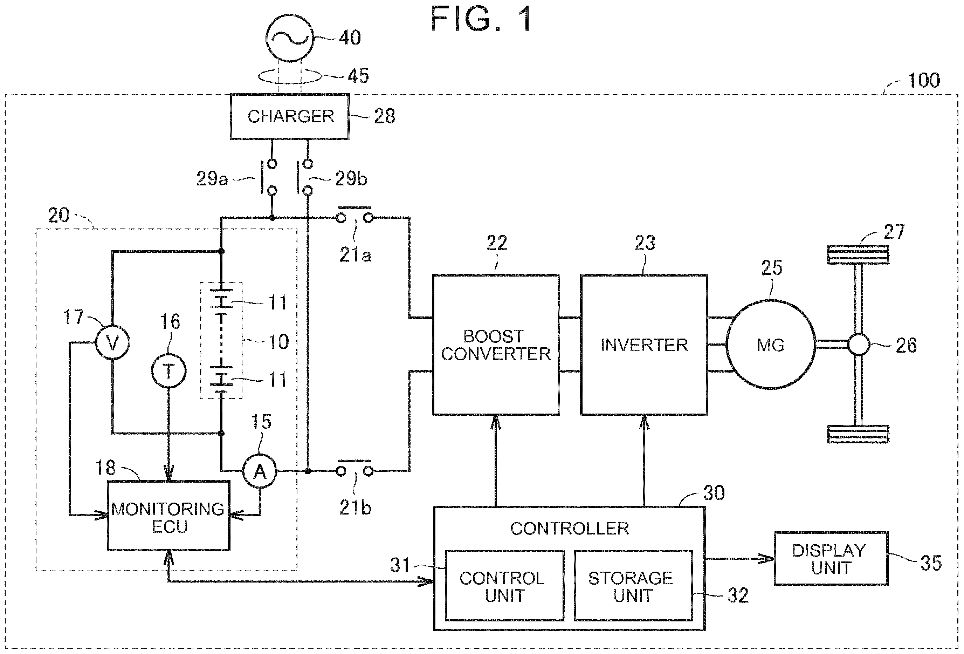

FIG. 1 is a block diagram showing an example of the configuration of a vehicle to which a display device according to an embodiment of the present invention is applied. Referring to FIG. 1, a vehicle 100 includes a main battery 10, a boost converter 22, an inverter 23, a motor generator 25, a transmission gear 26, drive wheels 27, and a controller 30.

The main battery 10 is mounted on the vehicle 100 as a driving power supply (i.e., a power source) for the vehicle 100. That is, the vehicle 100 is an electric or hybrid vehicle having the main battery 10 as a driving power supply for the vehicle. Hybrid vehicles are vehicles having an engine, a fuel cell, etc. (not shown) in addition to the main battery 10 as power sources for the vehicle 100. Electric vehicles are vehicles having only the main battery 10 as a power source for the vehicle 100.

The main battery 10 is formed by a battery pack 20 including a plurality of battery modules 11. Each battery module 11 includes a rechargeable secondary cell such as a lithium-ion secondary battery. Lithium-ion secondary batteries are secondary batteries using lithium ions as a charge carrier and may include what is called all-solid-state batteries using a solid electrolyte in addition to common lithium-ion secondary batteries using a liquid electrolyte.

The battery pack 20 includes a current sensor 15, a temperature sensor 16, a voltage sensor 17, and a battery monitoring unit 18. The battery monitoring unit 18 is formed by, e.g., an electronic control unit (ECU). The battery monitoring unit 18 is hereinafter sometimes referred to as the monitoring ECU 18.

The current sensor 15 detects the input/output current of the main battery 10 (hereinafter sometimes referred to as the battery current Ib). Hereinafter, regarding the battery current Ib, a discharge current is represented as a positive value and a charge current is represented as a negative value.

The temperature sensor 16 detects the temperature of the main battery 10 (hereinafter sometimes referred to as the battery temperature Tb). The battery pack 20 may include a plurality of temperature sensors 16. In this case, the weighted average, the highest value, or the lowest value of the temperatures detected by the plurality of temperature sensors 16 may be used as the battery temperature Tb, or the temperature detected by a specific one of the plurality of temperature sensors 16 may be used as the battery temperature Tb. The voltage sensor 17 detects the output voltage of the main battery 10 (hereinafter sometimes referred to as the battery voltage Vb).

The monitoring ECU 18 receives the detection values of the current sensor 15, the temperature sensor 16, and the voltage sensor 17 and outputs the battery voltage Vb, the battery current Ib, and the battery temperature Tb to the controller 30. Alternatively, the monitoring ECU 18 may store data of the battery voltage Vb, the battery current Ib, and the battery temperature Tb in a built-in memory (not shown).

The monitoring ECU 18 has a function to calculate the state of charge (SOC) of the main battery 10 by using at least a part of the battery voltage Vb, the battery current Ib, and the battery temperature Tb. The SOC refers to the remaining charge in the main battery 10 expressed as a percentage of the full charge capacity of the main battery 10. The controller 30 (described later) may have the function to calculate the SOC. Measurement information on the main battery 10 such as the battery current Ib, the battery temperature Tb, the battery voltage Vb, and the SOC is hereinafter sometimes referred to as the measurement data.

The main battery 10 is connected to the boost converter 22 via system main relays 21a, 21b. The boost converter 22 boosts the output voltage of the main battery 10. The boost converter 22 is connected to the inverter 23 and the inverter 23 converts the DC power from the boost converter 22 to AC power.

The motor generator (three-phase AC motor) 25 receives the AC power from the inverter 23 to generate kinetic energy for moving the vehicle. The kinetic energy generated by the motor generator 25 is transmitted to the drive wheels 27. When decelerating or stopping the vehicle 100, the motor generator 25 converts the kinetic energy of the vehicle 100 to electrical energy. The AC power generated by the motor generator 25 is converted to DC power by the inverter 23 and supplied to the main battery 10 through the boost converter 22. The regenerative electric power can thus be stored in the main battery 10. The motor generator 25 thus generates a driving or braking force for the vehicle 100, which involves reception and supply of electric power from and to the main battery 10 (i.e., charging and discharging of the main battery 10).

The boost converter 22 may be omitted. The inverter 23 may be omitted when a DC motor is used as the motor generator 25.

In the case where the vehicle 100 is configured as a hybrid vehicle further equipped with an engine (not shown) as a power source, the output of the engine in addition to the output of the motor generator 25 can be used as a driving force for moving the vehicle. Alternatively, the vehicle 100 may be equipped with another motor generator (not shown) that generates electric power by the engine output, so that charging power for the main battery 10 is generated by the engine output.

The controller 30 is formed by, e.g., an electronic control unit (ECU) and includes a control unit 31 and a storage unit 32. The storage unit 32 stores therein programs and various data for operating the control unit 31. The storage unit 32 may be configured so that the control unit 31 can read and write data from and to the storage unit 32, and the storage unit 32 may be provided outside the controller 30.

The controller 30 controls operation of the system main relays 21a, 21b, the boost converter 22, and the inverter 23. When a start switch (not shown) is turned on, the controller 30 turns on the system main relays 21a, 21b and operates the boost converter 22 and the inverter 23. When the start switch is turned off, the controller 30 turns off the system main relays 21a, 21b and stops operation of the boost converter 22 and the inverter 23.

The controller 30 has a function to calculate the capacity retention Q (described later) of the main battery 10. In the present embodiment, an example in which the capacity retention Q is calculated by a current integration method will be described later as a method for calculating the capacity retention Q. The monitoring ECU 18 may have the function to calculate the capacity retention Q.

The vehicle 100 further includes a display unit 35. The display unit 35 displays predetermined information to the user of the vehicle 100 in response to a control command from the controller 30. The display unit 35 can be formed by, e.g., a touch panel display using a liquid crystal panel.

The vehicle 100 may further has an external charging function to charge the main battery 10 by an external power supply 40. In this case, the vehicle 100 further includes a charger 28 and charging relays 29a, 29b.

The external power supply 40 is a power supply provided outside the vehicle 100. For example, a commercial AC power supply can be used as the external power supply 40. The charger 28 converts electric power from the external power supply 40 to charging power for the main battery 10. The charger 28 is connected to the main battery 10 via the charging relays 29a, 29b. When the charging relays 29a, 29b are on, the main battery 10 can be charged by using the electric power from the external power supply 40. Charging the main battery 10 with the external power supply 40 is hereinafter sometimes referred to as external charging.

The external power supply 40 and the charger 28 can be connected by, e.g., a charging cable 45. That is, the external power supply 40 and the charger 28 are electrically connected when mounting the charging cable 45. The main battery 10 can thus be charged with the external power supply 40. Alternatively, the vehicle 100 may be configured so that electric power is transmitted in a contactless manner between the external power supply 40 and the charger 28. For example, the main battery 10 can be charged with the external power supply 40 by transmitting electric power via a power transmitting coil (not shown) on the external power supply side and a power receiving coil (not shown) on the vehicle side.

As described above, in the case where AC power is supplied from the external power supply 40, the charger 28 is configured to have a function to convert the electric power (AC power) supplied from the external power supply 40 to charging power (DC power) for the main battery 10. Alternatively, in the case where the external power supply 40 directly supplies charging power for the main battery 10, the charger 28 need only transmit the DC power from the external power supply 40 to the main battery 10. The manner in which external charging of the vehicle 100 is performed is not particularly limited.

In the vehicle 100 configured as described above, as the full charge capacity of the main battery 10 decreases with its degradation, the distance the vehicle 100 can travel (EV cruising range) decreases accordingly. Specifically, the SOC refers to the remaining charge in the main battery 10 expressed as a percentage of the full charge capacity of the main battery 10. Accordingly, as the full charge capacity itself of the main battery 10 decreases with its degradation, the actual remaining charge (Wh) in the main battery 10 becomes lower even with the same SOC value (e.g., SOC = 100%). The EV cruising range is a parameter that also affects the value of the vehicle 100. The degradation level of the main battery 10 is therefore an important factor for the user. In the present embodiment, the degradation level of the main battery 10 together with the SOC of the main battery 10 is shown to the user on the display unit 35 as data indicating the state of the main battery 10.

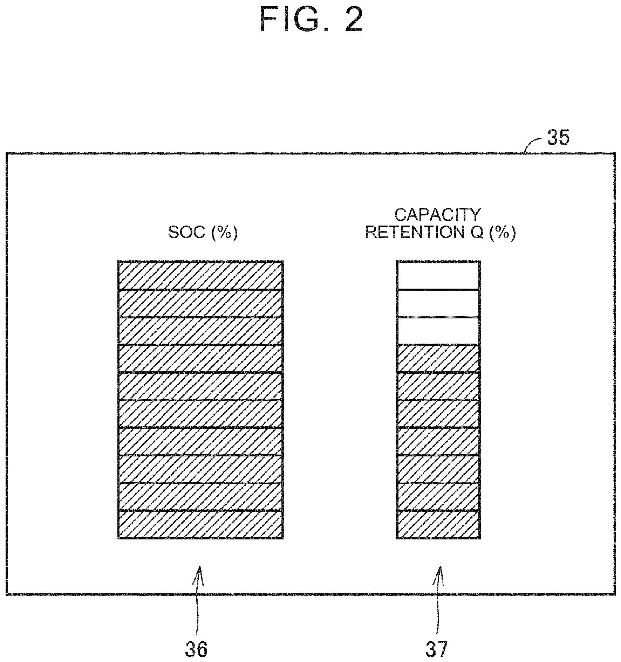

FIG. 2 is a diagram showing an example of display on the display unit 35. At least the SOC and the capacity retention as the degradation level of the main battery 10 are displayed on the display unit 35 of the present embodiment. For example, the capacity retention of the main battery 10 is defined as the current full charge capacity expressed as a percentage of the full charge capacity (Ah) of the brand-new main battery 10 (at the time of manufacturing) and is one of parameters from which the degradation level of the main battery 10 can be quantitatively evaluated. The above definition indicates that the higher the capacity retention is, the lower the degradation level of the main battery 10 is, and that the lower the capacity retention is, the higher the degradation level of the main battery 10 is.

Referring to FIG. 2, the current SOC of the main battery 10 is displayed in a region 36 of the display unit 35. The SOC values in the range from the upper limit (e.g., 100%) to the lower limit (e.g., 0%) are displayed in a predetermined number of segments. In this example, the SOC values are displayed in ten segments. Since overcharging and over-discharging of the main battery 10 facilitate degradation of the main battery 10, the upper limit of the SOC that is displayed in the region 36 may be lower than 100% (e.g., 90%) and the lower limit of the SOC that is displayed in the region 36 may be higher than 0% (e.g., 10%).

The current capacity retention (degradation level) Q of the main battery 10 is displayed in a region 37 of the display unit 35. Specifically, the capacity retention Q (%) is displayed in a plurality of segments. In this example, the capacity retention Q is displayed in ten segments.

Method for Calculating the Capacity Retention Q

The vehicle 100 moves while charging and discharging the main battery 10. In the case where the vehicle 100 has the external charging function, external charging of the main battery 10 is performed while the vehicle 100 is stopped. The main battery 10 degrades over time as it is charged and discharged.

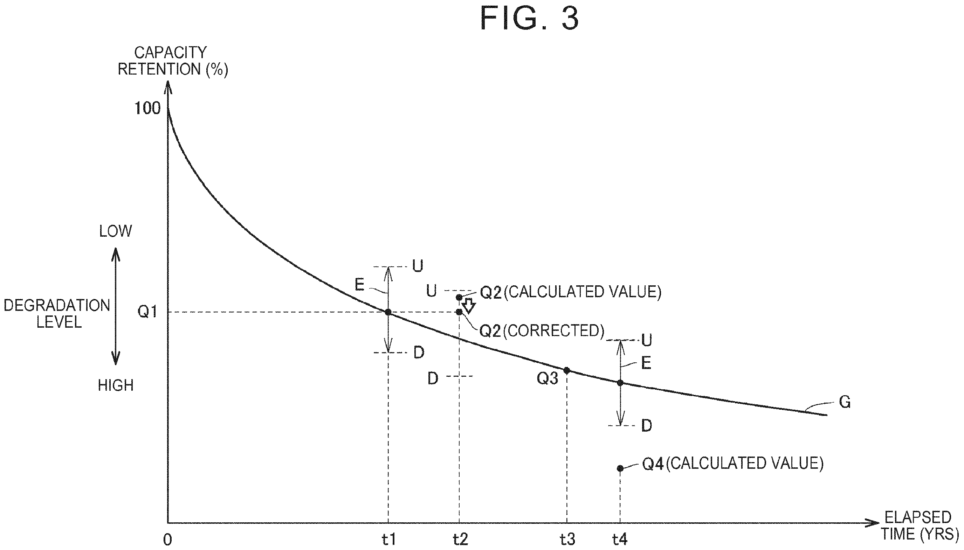

FIG. 3 is a graph showing an example of degradation characteristics (degradation curve) indicating degradation of the main battery 10 over time. In FIG. 3, the horizontal axis represents the time (years) elapsed since manufacturing of the main battery 10 or the vehicle 100, and the vertical axis represents the capacity retention (%) of the main battery 10.

Referring to FIG. 3, as described above, secondary batteries typically tend to degrade fast in the early stage immediately after manufacturing and then the degradation progresses at a stable pace. The main battery 10 also has such degradation characteristics. Namely, the degradation curve of the main battery 10 has a steep gradient in the early stage immediately after manufacturing (time 0).

An example of a method for calculating the capacity retention Q will be described. The amount of power ΔAh used to charge or discharge the main battery 10 while the SOC of the main battery 10 changes from SOC1 to SOC2 is measured by current integration using the current sensor 15. In this case, the controller 30 calculates the full charge capacity C of the main battery 10 by the following expression (1) by using SOC1, SOC2, and the amount of power ΔAh.

$$C = \Delta Ah/(SOC1 - SOC2) \times 100 \qquad \ldots (1)$$

The capacity retention Q of the main battery 10 is calculated by dividing the full charge capacity C calculated by the expression (1) by the initial value (e.g., the full charge capacity of the main battery 10 at the time of manufacturing) CO of the full charge capacity of the main battery 10. Specifically, the capacity retention Q of the main battery 10 is calculated by the following expression (2).

$$Q = C/C0 \times 100 \qquad \ldots (2)$$

The main battery 10 degrades over time, and the degradation level monotonically increases over time. In other words, as can be seen from FIG. 3, the capacity retention Q of the main battery 10 monotonically decreases over time. The expression "monotonically increase" means that the degradation level of the main battery 10 at a certain point is equal to or higher than that of the main battery 10 before that point. The expression "monotonically decrease" means that the capacity retention Q of the main battery 10 at a certain point is equal to or lower than that of the main battery 10 before that point.

The capacity retention Q thus calculated includes detection errors of various sensors that are used to calculate the capacity retention Q, a calculation error of the degradation level, etc. (hereinafter sometimes generally referred to as the "error E"). Accordingly, there is a possibility that when the capacity retention Q displayed on the display unit 35 is updated, the updated capacity retention Q may be higher than that displayed capacity retention Q due to the error E. In this case, the user of the vehicle 100 may get confused by the display as it seems as if the main battery 10 had become less degraded than before.

In the present embodiment, if the newly calculated capacity retention Q is higher than the displayed capacity retention (i.e., the previously calculated capacity retention), the newly calculated capacity retention Q is corrected so that it does not become higher than the previously calculated capacity retention.

This will be specifically described with reference to FIG. 3. For example, the capacity retention Q1 at elapsed time t1 may vary in the range from U to D in view of the error E. The error E can be calculated in advance based on the specifications of the various sensors (in the present embodiment in which the capacity retention Q is calculated by the current integration method, especially the current sensor 15) etc. used for the vehicle 100, the SOC calculation accuracy, etc.

It is herein assumed that the capacity retention Q2 (first degradation level) is calculated at elapsed time t2 and the previous capacity retention Q1 (second degradation level) was calculated at elapsed time t1. The previously calculated capacity retention Q1 is a value (true value) on the degradation curve of the main battery 10, and the newly calculated capacity retention Q2 is a value higher than the capacity retention Q1 due to the error E.

In this case, the value of the capacity retention Q2 is corrected to the value of the capacity retention Q1. By thus making the correction so as to reduce the influence of the error E, the newly calculated capacity retention Q2 is corrected so that it does not become higher than the previously calculated capacity retention Q1. The corrected capacity retention Q2 (= Q1) is displayed on the display unit 35. The capacity retention Q of the main battery 10 is thus restrained from being displayed as if the capacity retention Q had increased (that is, as if the degradation level had decreased). This reduces or eliminates the possibility that the user may get confused by the display of the capacity retention Q.

In case of abnormality such as a calculation error, it is presumed that the capacity retention varies more significantly than expected between the current and previous measurement times. In such a case, it is desired not to correct the newly calculated capacity retention in such a manner as described above and but to determine that the newly calculated capacity retention is an abnormal value.

It is herein assumed that the capacity retention Q4 (first degradation level) is calculated at elapsed time t4 and the previous capacity retention Q3 (second degradation level) was calculated at elapsed time t3.

An example of the capacity retention varying more significantly than expected between the current and previous measurement times, namely an example of the newly calculated capacity retention Q4 being different from the previously calculated capacity retention Q3 by an amount larger than the expected amount (threshold), is the case where the capacity retention Q4 calculated at elapsed time t4 is a value (abnormal value) that is out of the range, including the error E, relative to the value on the degradation curve G.

The threshold can be obtained by using the error E and the degradation curve G. The threshold can be stored in advance in the form of a calculation formula or mapped data in the storage unit 32 of the controller 30.

In the present embodiment, if the newly calculated capacity retention Q4 is different from the previously calculated capacity retention Q3 by an amount larger than the threshold, it is determined that the newly calculated capacity retention Q4 is an abnormal value, and the newly calculated capacity retention Q4 is discarded. The current capacity retention Q4 is then calculated again.

The abnormal value is thus restrained from being displayed as the capacity retention. This reduces or eliminates the possibility that the user may get confused by the display of the capacity retention.

Process to Be Executed by Controller

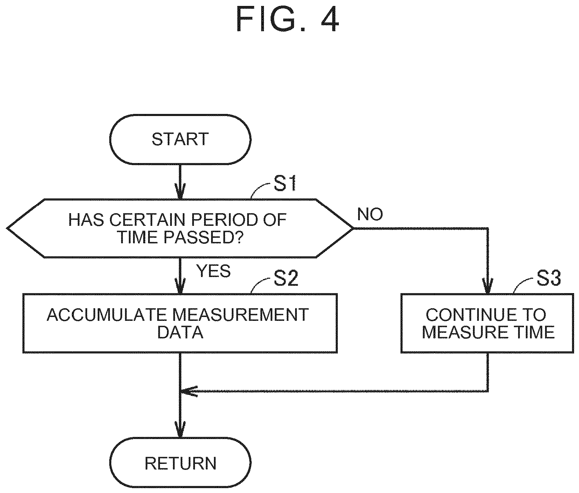

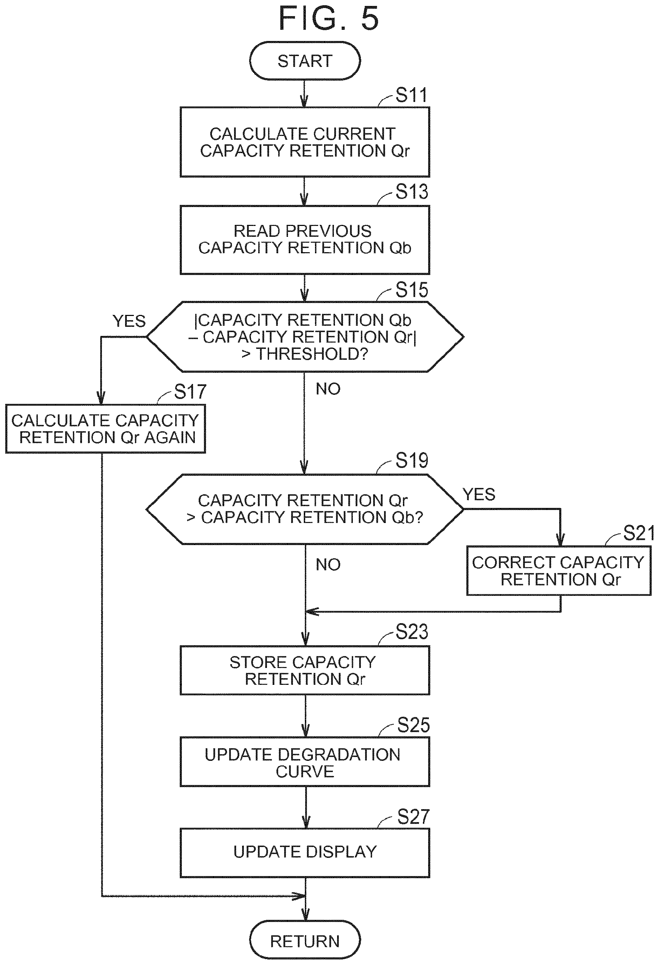

FIG. 4 is a flowchart illustrating a process of accumulating measurement data. The process shown in the flowchart can be executed by the controller 30. The flowchart of FIG. 4 and the flowchart of FIG. 5 described later are described with respect to the case where each step in these flowcharts is implemented by software processing of the controller 30. However, a part or all of the steps in each flowchart may be implemented by hardware (electrical circuit) in the controller 30.

Referring to FIG. 4, the controller 30 determines if a certain period of time (e.g., several hours) has passed since the previous transmission of measurement data (step S1). For example, the time elapsed since the previous collection of measurement data can be measured with a built-in timer, not shown, of the controller 30.

The controller 30 continues to measure time with the timer (S3) if the certain period of time has not passed (NO in S1). The controller 30 can obtain the measurement data of the main battery 10 (the battery current Ib, the battery voltage Vb, the battery temperature Tb, and the SOC) via the monitoring ECU 18 at any desired timing.

If it is determined in S1 that the certain period of time has passed (YES in S1), the controller 30 accumulates the measurement data of the main battery 10 in the storage unit 32 (S2). For example, data of the current SOC and battery current Ib is accumulated as the measurement data. In S2, the count value of the timer is cleared in response to the accumulation of the measurement data.

The measurement data may be instantaneous value data obtained in every certain period of time. Alternatively, data (average values) obtained by statistically processing the SOC, the battery current Ib, etc. within the certain period of time may be stored as the measurement data in the storage unit 32.

The process shown in FIG. 4 is executed both while the vehicle 100 is moving (the start switch is on) and while the vehicle 100 is not moving (the start switch is off). That is, the process of FIG. 4 is executed while the vehicle 100 is left parked and during external charging of the vehicle 100, and the use time of the main battery 10 includes both driving time and non-driving time of the vehicle 100.

FIG. 5 is a flowchart illustrating an example of a process of displaying the capacity retention Q of the main battery 10 on the display unit 35. The controller 30 repeats the steps in the flowchart in every predetermined period (e.g., in every several months etc.).

When the predetermined period has passed, the controller 30 starts executing the process shown in the flowchart and calculates the current capacity retention Qr (S11). Specifically, the controller 30 calculates the present (current) capacity retention Qr (degradation level) of the main battery 10 from the measurement data stored in the storage unit 32 by using the above expressions (1), (2).

The controller 30 then reads as the previous capacity retention Qb the capacity retention Qr stored in the storage unit 32 in S23 (described below) during the previous execution of the process shown in the flowchart (S13).

The controller 30 determines if the difference between the previous capacity retention Qb and the current capacity retention Qr is larger than a threshold (S15). If the difference between the previous capacity retention Qb and the current capacity retention Qr is larger than the threshold (YES in S15), the controller 30 determines that the current capacity retention Qr is an abnormal value, and the routine proceeds to S17. The controller 30 then calculates the capacity retention Qr again (S17). When calculating the capacity retention Qr again, the routine is returned so that the controller 30 executes the process shown in the flowchart again. The process shown in the flowchart may be configured so that the process is terminated if S17 has been repeated a predetermined number of times.

If the difference between the previous capacity retention Qb and the current capacity retention Qr is equal to or smaller than the threshold (NO in S15), the controller 30 determines if the capacity retention Qr is higher than the capacity retention Qb (S19).

If the capacity retention Qr is higher than the capacity retention Qb (YES in S19), the controller 30 determines that the calculated capacity retention Qr is higher than an actual value due to the error E, and corrects the value of the capacity retention Qr to the value of the capacity retention Qb (S21). The controller 30 then stores the corrected capacity retention Qr in the storage unit 32 (S23).

If the capacity retention Qr is equal to or lower than the capacity retention Qb (NO in S19), the controller 30 stores the capacity retention Qr calculated in S11 in the storage unit 32 (S23).

The controller 30 uses the capacity retention Qr to update the degradation curve G so that the degradation curve G becomes closer to the capacity retention Qr (S25). In the initial period after start of use of the main battery 10, the controller 30 corrects a reference degradation curve determined in advance based on the characteristics of the main battery 10. After the initial period, the controller 30 updates the updated degradation curve every time it calculates the capacity retention Qr. For example, the reference degradation curve can be obtained in advance based on data of degradation over time which is obtained by experiments conducted under a standard use environment. The reference degradation curve is stored in, e.g., the storage unit 32 of the controller 30.

The controller 30 updates the capacity retention displayed on the display unit 35 with the capacity retention Qr stored in S23 (S27).

As described above, in the case where the newly calculated capacity retention is higher than the previously calculated capacity retention, the value of the newly calculated capacity retention is corrected to the value of the previously calculated capacity retention, and the corrected capacity retention is displayed on the display unit 35. The capacity retention Q of the main battery 10 is thus restrained from being displayed as if the capacity retention Q had increased (that is, as if the degradation level had decreased). This reduces or eliminates the possibility that the user may get confused by the display of the capacity retention Q.

If the newly calculated capacity retention is different from the previously calculated capacity retention by an amount larger than the threshold, it is determined that the newly calculated capacity retention is an abnormal value, and the capacity retention is calculated again. The abnormal value is thus restrained from being displayed as the capacity retention. This reduces or eliminates the possibility that the user may get confused by the display of the capacity retention.

First Modification

The embodiment is described with respect to an example in which, if the newly calculated capacity retention is higher than the previously calculated capacity retention, the value of the newly calculated capacity retention is corrected to the value of the previously calculated capacity retention. However, in the case where the newly calculated capacity retention is higher than the previously calculated capacity retention, the newly calculated capacity retention to be displayed need only be corrected to a value equal to or lower than the previously calculated capacity retention. In a first modification, if the newly calculated capacity retention is higher than the previously calculated capacity retention, the value of the newly calculated capacity retention is corrected to the value of the capacity retention estimated from the previously calculated capacity retention.

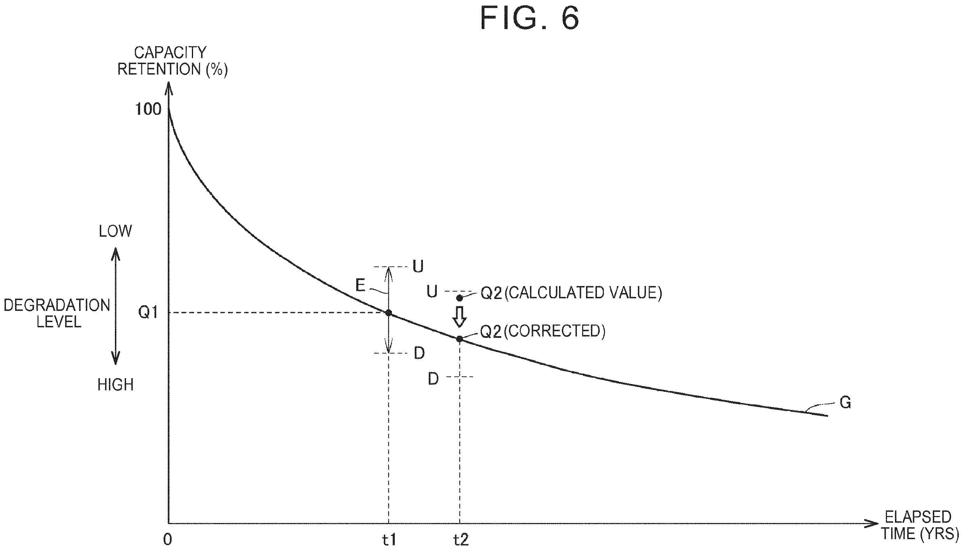

FIG. 6 is a graph illustrating correction of the capacity retention. As in the embodiment, it is herein assumed that the capacity retention Q2 (first degradation level) is calculated at elapsed time t2 and the previous capacity retention Q1 (second degradation level) was calculated at elapsed time t1.

As described regarding S25 in FIG. 5 in the embodiment, the degradation curve G is updated when the previous capacity retention Q1 is calculated. The current capacity retention Q2 can be estimated by checking the elapsed time t2, which is the time the current capacity retention is calculated, against the degradation curve G.

If the newly calculated capacity retention Q2 is higher than the previously calculated capacity retention Q1, the value of the newly calculated capacity retention Q2 is corrected to the value of the capacity retention estimated from the degradation curve G updated by using the previous capacity retention Q1. As in the embodiment, the capacity retention Q of the main battery 10 is thus restrained from being displayed as if the capacity retention Q had increased (that is, as if the degradation level had decreased). This reduces or eliminates the possibility that the user may get confused by the display of the capacity retention Q.

Second Modification

The embodiment is described with respect to an example in which the capacity retention Q is calculated in every predetermined period. However, the timing the capacity retention Q is calculated is not limited to every predetermined period. For example, the capacity retention Q may be calculated every time external charging is performed.

For example, when external charging is started and the SOC of the main battery 10 reaches a predetermined SOC value (SOC1: e.g., 20%), the controller 30 obtains the measurement data of the main battery 10 from the monitoring ECU 18 and starts current integration and measurement of time. The controller 30 stops current integration and measurement of time when the SOC of the main battery 10 reaches full charge (SOC2: e.g., 100%). The controller 30 calculates the amount of power $\Delta Ah$ used to charge the main battery 10 while the SOC of the main battery 10 changes from SOC1 to SOC2. Specifically, the controller 30 calculates the amount of power $\Delta Ah$ by integrating the battery current Ib obtained from the monitoring ECU 18.

The controller 30 calculates the full charge capacity C of the main battery 10 by the above expression (1) by using SOC1 and SOC2 of the main battery 10 and the amount of power $\Delta$Ah. The controller 30 then calculates the capacity retention Q by the above expression (2) by using the calculated full charge capacity C and the initial value CO of the full charge capacity of the main battery 10.

Input and output of electric power to and from the main battery 10 is more stable during external charging than during traveling of the vehicle 100 etc. Since the capacity retention Q is calculated as described above, the capacity retention Q can be calculated under a stable environment.

Third Modification

In the embodiment, the full charge capacity of the main battery 10 is given in "Ah" and the capacity retention (current capacity retention) of the main battery 10 indicates the degradation level. However, for example, the full charge capacity of the main battery 10 may be given in "Wh" and the capacity retention (power capacity retention) of the main battery 10 may indicate the degradation level.

Fourth Modification

In the embodiment, the capacity retention Q of the main battery 10 indicates the degradation level. However, for example, as the full charge capacity C of the main battery 10 decreases with its degradation, the upper limit of the EV cruising range of the fully charged main battery 10 also decreases accordingly. Accordingly, the upper limit of the EV cruising range of the fully charged main battery 10 may indicate the degradation level. For example, the EV cruising range can be calculated by multiplying the average kilometers per kWh (km/kWh) of the vehicle 100 by the current full charge capacity (kWh).

Fifth Modification

In the embodiment, the degradation level of the main battery 10 is calculated, corrected, and displayed by the controller 30 and the display unit 35 of the vehicle 100. However, the degradation level of the main battery 10 may be calculated, corrected, and displayed by a system outside the vehicle 100.

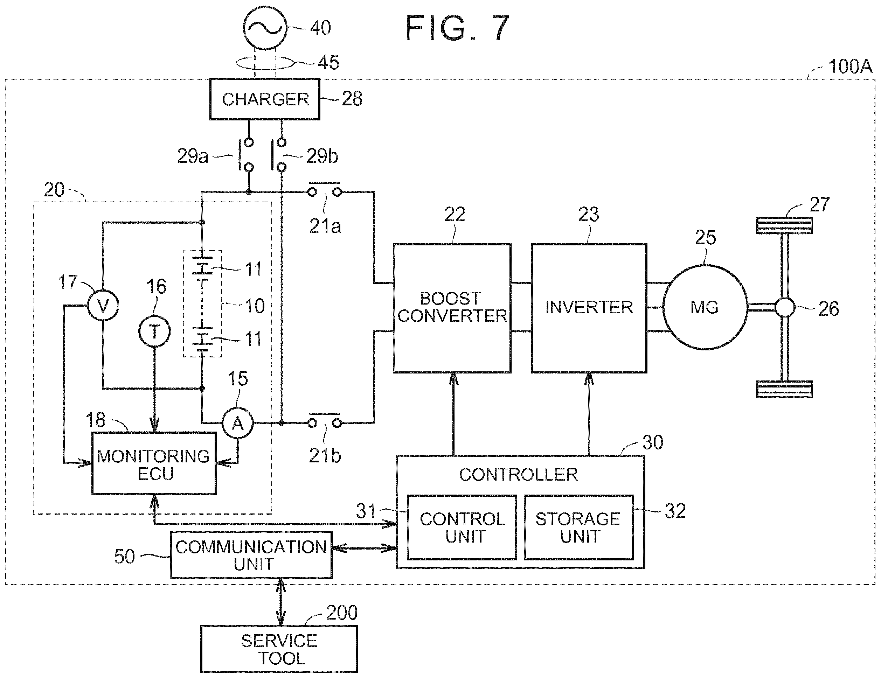

FIG. 7 is a block diagram showing an example of the configuration in which the degradation level of the main battery 10 is calculated, corrected, and displayed outside the vehicle. Referring to FIG. 7, in this modification, a vehicle 100A has the same configuration as that of the vehicle 100 shown in FIG. 1 except that the vehicle 100A does not include the display unit 35 and further includes a communication unit 50.

The communication unit 50 has a function to communicate with a service tool 200 provided outside the vehicle 100A. Communication with the service tool 200 may be either wired or wireless communication. The communication unit 50 may be formed by, e.g., an on-board communication module.

The service tool 200 is provided at, e.g., a car dealer etc. and the degradation level of the main battery 10 is calculated from the measurement data of the main battery 10 obtained from the vehicle 100A. In the vehicle 100A, the measurement data of the main battery 10 has been collected and accumulated in the storage unit 32. When communication between the service tool 200 and the communication unit 50 is established, the communication unit 50 transmits the measurement data accumulated in the storage unit 32 to the service tool 200.

In the service tool 200, the current degradation level of the main battery 10 is calculated from the measurement data obtained from the vehicle 100A. As in the embodiment, the degradation level is, e.g., the current capacity retention Q of the main battery 10. The capacity retention of the main battery 10 can be calculated by using the above expressions (1), (2).

In the service tool 200, the process shown in the flowchart of FIG. 5 is executed. If the newly calculated capacity retention is higher than the previously calculated capacity retention, the value of the newly calculated capacity retention is corrected to the value of the previously calculated capacity retention. The corrected capacity retention is displayed on a display unit (not shown) of the service tool 200. The capacity retention Q of the main battery 10 is thus restrained from being displayed as if the capacity retention Q had increased (that is, as if the degradation level had decreased). This reduces or eliminates the possibility that the user may get confused by the display of the capacity retention Q.

If the newly calculated capacity retention is different from the previously calculated capacity retention by an amount larger than the threshold, it is determined in the service tool 200 that the newly calculated capacity retention is an abnormal value, and the capacity retention is calculated again. The abnormal value is thus restrained from being displayed as the capacity retention. This reduces or eliminates the possibility that the user may get confused by the display of the capacity retention.

In the embodiment, the degradation level of the main battery 10 is calculated and corrected by the controller 30 of the vehicle 100. However, the degradation level may be calculated and corrected by a server outside the vehicle.

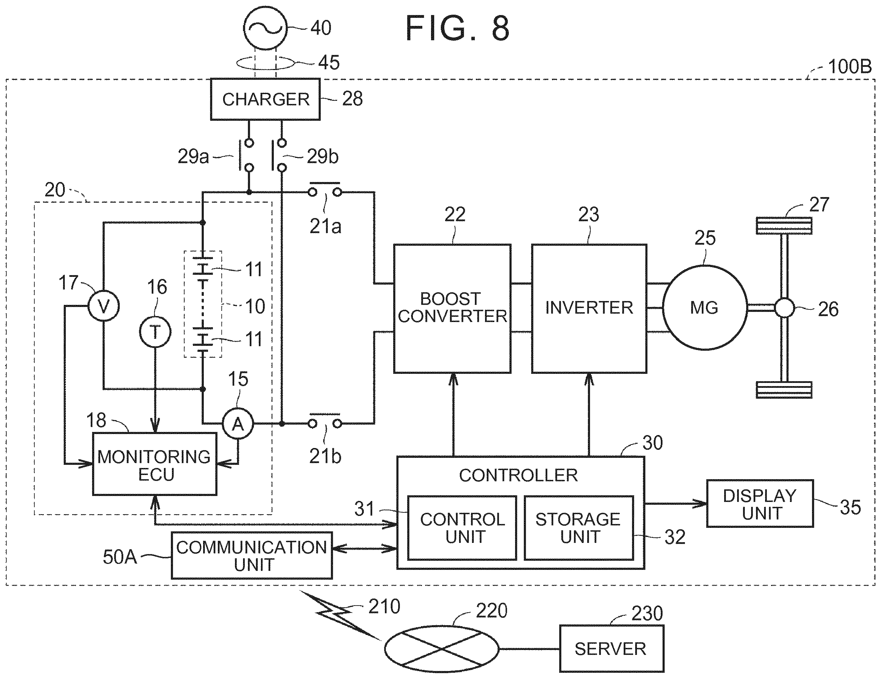

FIG. 8 is a block diagram showing an example of the configuration in which the degradation level of the main battery 10 is calculated and corrected outside the vehicle. Referring to FIG. 8, in this modification, a vehicle 100B has the same configuration as that of the vehicle 100 shown in FIG. 1 except that the vehicle 100B further includes a communication unit 50A.

The communication unit 50A has a function to form a communication path 210 between the communication unit 50A and a server 230 provided outside the vehicle 100B to establish wireless communication therebetween. For example, the communication unit 50A can be formed by an on-board wireless communication module.

The vehicle 100B can provide two-way data communication between the vehicle 100B and the server 230 by connecting to a wide area network 220 (typically the Internet) via the communication path 210 formed by the communication unit 50A. The vehicle 100B transmits measurement data of the main battery 10 to the server 230 in every predetermined period.

When the server 230 obtains the measurement data of the main battery 10 from the vehicle 100B, the server 230 calculates the degradation level of the main battery 10 from the obtained measurement data. For example, the degradation level is the current capacity retention Q of the main battery 10 as in the embodiment. The capacity retention Q of the main battery 10 can be calculated by using the above expressions (1), (2).

The process shown in the flowchart of FIG. 5 is executed in the server 230. If the newly calculated capacity retention is higher than the previously calculated capacity retention, the value of the newly calculated capacity retention is corrected to the value of the previously calculated capacity retention. The server 230 transmits the calculated capacity retention (if the correction has been made, the corrected capacity retention) to the vehicle 100B. The vehicle 100B displays the capacity retention Q received from the server 230 on the display unit 35.

The embodiment and the first to fifth modifications may be either entirely or partially combined.

In the embodiment and the first to fifth modifications, the display device is applied to a vehicle. However, the display device of the present invention is not limited to applications to vehicles and may be applied to other devices that display the degradation level of a secondary battery.

**Claims**

1. A display device, comprising:

   a display unit (35) configured to display a degradation level of a secondary battery (10); and
   a controller (30) configured to calculate the degradation level from measurement data of the secondary battery (10) in every predetermined period and to control the display unit (35) so as to display the degradation level, wherein
   the controller (30) is configured to, when a first degradation level indicating a newly calculated degradation level of the secondary battery is lower than a second degradation level indicating a previously calculated degradation level of the secondary battery, correct the first degradation level to a value equal to or higher than the second degradation level and to control the display unit (35) so as to display the corrected first degradation level.

2. The display device according to claim 1, wherein
   the controller (30) is configured to, when the first degradation level is lower than the second degradation level, correct the first degradation level to a value equal to the second degradation level and to control the display unit (35) so as to display the corrected first degradation level.

3. The display device according to claim 1, wherein
   the controller (30) is configured to, when the first degradation level is lower than the second degradation level, correct the first degradation level to a degradation level estimated from the second degradation level and to control the display unit (35) so as to display the corrected first degradation level.

4. The display device according to any one of claims 1 to 3, wherein
   the controller (30) is configured to calculate the first degradation level again when a difference between the first degradation level and the second degradation level is larger than a threshold.

5. A vehicle, comprising:

   a secondary battery (10); and
   a display device according to any one of claim 1 to 4.

**Patentansprüche**

1. Anzeigeeinrichtung mit:

   einer Anzeigeeinheit (35), die dazu konfiguriert ist, ein Verschlechterungslevel einer Sekundärbatterie (10) anzuzeigen; und
   einer Steuerung (30), die dazu konfiguriert ist, das Verschlechterungslevel von Messdaten der Sekundärbatterie (10) in jeder vorbestimmten Periode zu berechnen und die Anzeigeeinheit (35) zu steuern, um das Verschlechterungslevel anzuzeigen, wobei
   die Steuerung (30) dazu konfiguriert ist, wenn ein erstes Verschlechterungslevel, das ein neu berechnetes Verschlechterungslevel der Sekundärbatterie angibt, niedriger ist als ein zweites Verschlechterungslevel, das ein vorher berechnetes Verschlechterungslevel der Sekundärbatterie angibt, das erste Verschlechterungslevel auf einen Wert zu korrigieren, der gleich oder höher als das zweite Verschlechterungslevel ist, und die Anzeigeeinheit (35) zu steuern, um das korrigierte erste Verschlechterungslevel anzuzeigen.

2. Anzeigeeinrichtung gemäß Anspruch 1, wobei
   die Steuerung (30) dazu konfiguriert ist, wenn das erste Verschlechterungslevel niedriger ist als das zweite Verschlechterungslevel, das erste Verschlechterungslevel auf einen Wert zu korrigieren, der gleich dem zweiten Verschlechterungslevel ist, und die Anzeigeeinheit (35) zu steuern, um das korrigierte erste Verschlechterungslevel anzuzeigen.

3. Anzeigeeinrichtung gemäß Anspruch 1, wobei
   die Steuerung (30) dazu konfiguriert ist, wenn das erste Verschlechterungslevel niedriger ist als das zweite Verschlechterungslevel, das erste Verschlechterungslevel auf ein Verschlechterungslevel zu korrigieren, das von dem zweiten Verschlechterungslevel geschätzt wird, und die Anzeigeeinheit (35) zu steuern, um das korrigierte erste Verschlechterungslevel anzuzeigen.

4. Anzeigeeinrichtung gemäß einem der Ansprüche 1 bis 3, wobei
   die Steuerung (30) dazu konfiguriert ist, das erste Verschlechterungslevel wiederholt zu berechnen, wenn eine Differenz zwischen dem ersten Verschlechterungslevel und dem zweiten Verschlechterungslevel größer als ein Schwellenwert ist.

5. Fahrzeug, mit:

   einer Sekundärbatterie (10); und
   einer Anzeigeeinrichtung gemäß einem der Ansprüche 1 bis 4.


**Revendications**

1. Dispositif d'affichage, comprenant :

   une unité d'affichage (35) configurée pour afficher un niveau de dégradation d'une batterie secondaire (10) ; et
   un dispositif de commande (30) configuré pour calculer le niveau de dégradation à partir de données de mesure de la batterie secondaire (10) à chaque période prédéterminée et pour commander l'unité d'affichage (35) de manière à afficher le niveau de dégradation, dans lequel
   le dispositif de commande (30) est configuré pour, lorsqu'un premier niveau de dégradation indiquant un niveau de dégradation nouvellement calculé de la batterie secondaire est inférieur à un deuxième niveau de dégradation indiquant un niveau de dégradation précédemment calculé de la batterie secondaire, corriger le premier niveau de dégradation à une valeur égale ou supérieure au deuxième niveau de dégradation et pour commander l'unité d'affichage (35) de manière à afficher le premier niveau de dégradation corrigé.

2. Dispositif d'affichage selon la revendication 1, dans lequel
   le dispositif de commande (30) est configuré pour, lorsque le premier niveau de dégradation est inférieur au deuxième niveau de dégradation, corriger le premier niveau de dégradation à une valeur égale au deuxième niveau de dégradation et pour commander l'unité d'affichage (35) de manière à afficher le premier niveau de dégradation corrigé.

3. Dispositif d'affichage selon la revendication 1, dans lequel

le dispositif de commande (30) est configuré pour, lorsque le premier niveau de dégradation est inférieur au deuxième niveau de dégradation, corriger le premier niveau de dégradation à un niveau de dégradation estimé à partir du deuxième niveau de dégradation et pour commander l'unité d'affichage (35) de manière à afficher le premier niveau de dégradation corrigé.

4. Dispositif d'affichage selon l'une quelconque des revendications 1 à 3, dans lequel
le dispositif de commande (30) est configuré pour recalculer le premier niveau de dégradation lorsqu'une différence entre le premier niveau de dégradation et le deuxième niveau de dégradation est supérieure à un seuil.

5. Véhicule, comprenant :

une batterie secondaire (10) ; et
un dispositif d'affichage selon l'une quelconque des revendications 1 à 4.

FIG. 1

EP 3 640 071 B1

13

# FIG. 2

FIG. 3

# FIG. 4

START

S1

HAS CERTAIN PERIOD OF
TIME PASSED?

NO

YES

S2

ACCUMULATE MEASUREMENT
DATA

S3

CONTINUE TO
MEASURE TIME

RETURN

# FIG. 5

START

S11
CALCULATE CURRENT
CAPACITY RETENTION Qr

S13
READ PREVIOUS
CAPACITY RETENTION Qb

S15
|CAPACITY RETENTION Qb
– CAPACITY RETENTION Qr|
> THRESHOLD?

YES

NO

S17
CALCULATE CAPACITY
RETENTION Qr AGAIN

S19
CAPACITY RETENTION Qr
> CAPACITY RETENTION Qb?

YES

NO

S21
CORRECT CAPACITY
RETENTION Qr

S23
STORE CAPACITY
RETENTION Qr

S25
UPDATE DEGRADATION
CURVE

S27
UPDATE DISPLAY

RETURN

# FIG. 6

EP 3 640 071 B1

FIG. 7

EP 3 640 071 B1

# FIG. 8

EP 3 640 071 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018029430 A
- US 2018188332 A1